# EUROPEAN PATENT APPLICATION

(11) **EP 1 340 837 A1**
(43) Date of publication of application: **03.09.2003**
(21) Application number: 02075815.7
(22) Date of filing: 01.03.2002
(51) Int. Cl.: C23C 16/27, C23C 16/02

(54) **Process for diamond coating of an iron-based substrate**

(71) Applicant: STICHTING VOOR DE TECHNISCHE WETENSCHAPPEN, 3527 JP Utrecht (NL)
(72) Inventor: van Enckevort, Wilhelmus Johannes Petrus, 5921 CR Blerick (NL); Schermer, Johannes Jacobus, 6545 LS Nijmegen (NL); Buijnsters, Josephus Gerardus, 6525 JH Nijmegen (NL); Shankar, Prabhakaran, Kalpakkam 603 102, Tamilnadu (IN); ter Meulen, Johannes Joseph, 6533 ZH Nijmegen (NL)
(74) Representative: Prins, Adrianus Willem

(57) **Abstract**

A method of forming a diamond coating on an iron-based substrate, comprising: providing an iron based substrate with an outer layer which substantially comprises metal borides; and depositing the diamond coating on the outer layer using a process of Chemical Vapour Deposition (CVD).

Said outer layer may be formed by deposition, by depositing a metal layer which is capable of being boronized followed by boronizing said metal layer, or by boronizing said iron-based substrate. The invention is also related to the use of an iron-based substrate comprising an outer layer with substantially borides for hosting a CVD diamond coating.

## Description

The invention relates to a method of forming a diamond coating on an iron-based substrate and to the use of a particular iron-based substrate for a diamond coating.

Such a method is known from US-A-5,759,623 which discloses a pretreatment step of supersaturating an iron-based surface with carbon prior to the deposition of a diamond coating. The deposition involves a Chemical Vapour Deposition (CVD) process.

For a relatively long time it has been known how to deposit from a gas phase a polycrystalline diamond coating on a selected substrate. The substrate is exposed to a gas mixture comprising at least a carbonaceous compound which is activated. Often methane is used together with hydrogen in such a gas mixture. The activation of the gas mixture generally requires severe conditions such as high gas temperatures of well above 2000 °C or microwave radiation. The substrate is generally kept at an elevated temperature (typically 900 °C) and comprises a well chosen ceramic such as silicon or a relatively expensive metal such as molybdenum.
Given the superior properties of diamond in terms of hardness, wear resistance, and chemical stability, and given the well-known properties, advantages and many applications of iron and steel, it is desirable to have a CVD diamond coating on a steel or iron substrate. Such a combination of a coating and a substrate will provide a cost-effective substitute for tools fabricated out of materials such as cemented carbides which are often used in industrial applications. The CVD process that is used in the present invention, is a particular suitable way of applying diamond and is well documented. See for example: "CVD diamond films: nucleation and growth" ; S.-Tong Lee , Zhangda Lin and Xin Jiang , Materials science and Engineering R (Reports: A review journal), 25 (1999) 123-154, which document is incorporated herein by reference to provide process equipment and process conditions for the CVD process used in the process of the invention.

However, as said, during the CVD process the substrate temperature is kept at a high temperature. Within a temperature range from this high temperature down to room temperature there is a very high difference in thermal expansion coefficient between iron or steel and diamond. This leads to high interface stresses during cooling down from the deposition temperature. As a result, the coating may delaminate from the surface or give rise to other disadvantageous effects.

It is for instance possible that the coating only partly delaminates at patches on the interface, therewith releasing stress and reducing adherence to the substrate.

If a coating remains completely attached to the surface, the interface stress within the coating can be enormously high enhancing the likelihood that the coating will delaminate during subjection to practical applications.

The residual stress in a coating can be measured as indicative of the interface stress. Ideally, the deposition process results in a continuous diamond coating with a low residual stress. In practice, this has proven to be a difficult task.

Apart from stress related problems the deposition of diamond on steel is hampered by the fact that materials containing iron phases at the surface favour formation of graphite instead of formation of diamond at deposition conditions, further inhibiting formation of a well adhering diamond coating on steel. Also, the high solubility of carbon in iron phase containing substrates appears to hinder formation of CVD diamond coating.

In attempts to solve these problems, interlayer systems have been developed with attempts to 1) suppress diffusion of iron to the substrate surface, 2) suppress diffusion of carbon into the iron phase, and 3) accommodate for and/or reduce the high interface stresses.

Reports have been published on the use of overlay coatings, which are deposited on top of the steel substrates prior to CVD diamond deposition. These overlay coatings may have a thickness of the order of several micrometers and are mainly produced by Physical Vapour Deposition (PVD) techniques. Some examples involve the use of molybdenum, nickel, titanium nitride and chromium nitride interlayers.

None of these overlay coatings have been proven to be very successful as an abrupt change in the elastic, thermal and/or mechanical properties is present at the interface with the deposited diamond coating. These changes lead to high interface stresses, which often result in delamination during cooling down from deposition temperature and if not, ultimately to premature failure during use in industrial applications. Also the interlayer/steel interface is abrupt, enhancing the likelihood of failure of this layer system at a depth further away from the diamond coating.

In a further attempt to overcome at least some of these problems, a diffusion modified overlay coating has been employed. Hereto, a chromium layer was deposited on a steel substrate by means of electroplating and this chromium layer was subsequently nitrided by passing a gas mixture comprising nitrogen.

This has within the overlay coating resulted in - towards the iron-based substrate - gradually changing properties such as elasticity, hardness and thermal expansion of the material, leading to a slightly better accommodation of the thermal stress during the CVD diamond deposition process. However, there remains a large mismatch in the thermal and mechanical properties at the interface of a diamond coating and the substrate surface, as well as an abrupt change in properties at the chromium/steel interface introducing weak interfaces in the layer system. Also very high residual stresses (indicative of high interface stresses) have been observed within the diamond films deposited on this layer system, limiting the scope of applications.

It should further be noted that this method of producing an interlayer system includes three steps for obtaining a CVD diamond coating on steel. Each step is carried out in a different reactor, making the method complicated and costly. These steps are: 1) electroplating, 2) nitriding and 3) depositing diamond.

Said US-A-5,759,623 discloses supersaturation of an iron based substrate with carbon by heating the substrate and exposing it to a carbon atom donor substance. It is suggested that by in-diffusion of carbon a diffusion barrier is formed in the iron based substrate. A black carbon deposit is formed on the surface of the substrate and after removing this deposit the substrate is suitable for diamond to be deposited on the surface thereof.

However, at least the following two problems remain. During the CVD process, carbon already present in the iron-based substrate diffuses further away from the surface, thereby slowly dissolving the diffusion barrier at a side adjacent to the matrix of the iron-based substrate. This allows for more iron to diffuse to the surface, hampering the formation of diamond during deposition. Iron may also catalytically aid the transformation of diamond to the more stable form of graphite. A further detrimental result of the presence of iron at the interface with the diamond coating that may occur is premature delamination of the diamond coating in use due to conditions where the diamond coating is subjected to heat. Another problem is that a large mismatch in properties is still present between diamond and the surface of the supersaturated iron based substrate. The Vickers hardness of carburised steel surfaces is reported to be about 1,000, whereas the diamond grains themselves have a VHN (VHN = Vickers Hardness Number) of 10,000.

It is an object of the invention to provide a method of forming a diamond coating on an iron-based substrate, which is improved with respect to methods known of the prior art, or at least, solves one or more of the problems known in the art. Further advantages of the process of the present invention will become clear when reading the description herein-below.

The present inventors have found that a specific outer surface layer of an iron based substrate allows for deposition of a diamond coating.

More in detail, the present invention relates to a method of forming a diamond coating on an iron-based substrate, comprising the steps of:
- providing an iron based substrate with an outer layer which substantially comprises metal borides; and
- depositing the diamond coating on the outer layer using a process of Chemical Vapour Deposition (CVD).

Within this specification and the appending claims, the outer layer is understood to be an intentionally produced layer which is different from the matrix of the unaffected iron based substrate.

With "an outer layer which substantially comprises metal borides" is meant an outer layer of which the X-ray diffraction pattern reveals phases of metal borides, preferably in a significant amount. The carbon solubility of such metal borides is negligibly small. X-ray diffraction patterns of the outer layer obtained after exposure of the outer layer to a carbonaceous material under diamond deposition conditions show that no significant carburisation of the outer layer occurs prior to diamond nucleation. Without wishing to be bound by any theory, it is believed that these metal borides act as an effective diffusion barrier for carbon. In accordance with the present invention, this allows for the use of an iron based substrate with such an outer layer for hosting a CVD diamond coating. Raman spectroscopy has shown that good quality diamond is grown on the outer layer after exposure to CVD diamond conditions. From the position of first order the Raman diamond peak it also follows that compared to residual stress in CVD diamond coatings deposited on the outer layers known of the prior art, the CVD diamond coatings deposited on the outer layers substantially comprising borides show relatively little residual stress. Furthermore, the diamond coatings are found to be adherent to the outer layer which substantially comprises metal borides. The thickness of the outer layer is likely to be in the order of a micrometer or more, although a thinner layer is not thought to be impossible. Those skilled in the art will easily find for each particular combination of substrate and diamond coating a suitable thickness of the outer layer.

In one preferred embodiment of the method according to the invention the outer layer is formed by deposition. Physical Vapour Deposition (PVD), for instance, allows for deposition of a metal boride. Using this method it is even possible to deposit an outer layer which gradually changes in composition from comprising predominantly iron borides at the very surface of the outer layer to almost entirely a metal phase closer to the interface of the outer layer with the iron based substrate. With such an outer layer the thermal and mechanical properties will vary from relatively close to the thermal and mechanical properties of the iron based substrate at the interface of the outer layer and the iron based substrate to relatively close to the thermal and mechanical properties of diamond at the very surface of the outer layer. This outer layer is much more suitable for accommodating residual stress which results after the deposition of diamond. To obtain such an outer layer, a metal boride source and a metal source may be employed in the PVD reactor. For those skilled in the art it is no problem to find the process parameters which ensure deposition of this type of metal boride outer layer. It is also within the scope of the skilled man to obtain a desired thickness of this outer layer and a desired gradient in composition.

In another embodiment of the method according to the invention, the outer layer is formed by depositing a metal layer which is capable of being boronized followed by boronizing the metal layer. The metal layer may be deposited by electroplating, PVD, or any other suitable technique. Boronizing is a well known and a well documented technique and comprises the in-diffusion of boron in the metal layer. Hereto, the iron based substrate with the deposited metal layer is exposed to gaseous, liquid, or solid boron-yielding compounds at elevated temperatures. By this technique, a metal boride outer layer is formed onto which a CVD diamond coating can be deposited. It should be noted that in the field of boronizing for the same process is also commonly used the term "boriding".

In a more preferred embodiment of the method according to the invention, the outer layer is formed by boronizing said iron-based substrate. This embodiment only needs one step, the boronizing step, to form the outer layer which comprises metal borides. Furthermore, in comparison to outer layers obtained by PVD techniques, the boronizing steel surface will not suffer from shadow effects or require complicated reactors in which the steel substrate is, e.g. rotated, to obtain an outer layer on substrates with a complicated geometry. Boronizing an iron-based substrate prior to CVD diamond deposition provides a simple and relatively cheap method for obtaining an outer layer which is suitable for hosting a CVD diamond coating.

Boronizing is, as stated before, a well known technique. See for example: "Microstructural and Microchemical Modifications on Interrupted Boriding of Medium Carbon Steel, by P. Gopalakrishnan, P. Shankar, M. Palaniappa, S.S. Ramakrishnan, Accepted for publication in Metall. Mater. Trans. A, which accepted article is filed together with the present application.

In this technique boron yielding compounds and the substrate are heated up to temperatures at which boron atoms become free from the boron yielding compounds and at which these boron atoms diffuse with a reasonable mobility into the matrix of the iron-based substrate. The state of the boron yielding compounds may be gaseous, liquid or solid.

As a gas, borontrifluoride, borontrichloride, or borontribromide may be used, although their sensitivity to even the slightest traces of moisture have made these gases rather uncommon in the field. Diborane is also sensitive to moisture and is poisonous. Alternatives may be trimethyl boride and triethyl boride. In practice, the substrate usually is kept in an induction or a tube furnace through which the gases are led.

More preferable is the use of liquid compounds in molten salt. Boronizing can occur with and without electrolysis. Also aqueous solutions with high frequency heating are practised. Typically, compounds such as borax, anhydrous borax, metaboric acid, sodium borofluoride, boric acid anhydride and boron carbide are used for boronizing methods involving electrolysis. The substrate is suitably cathodically connected in molten borax, while a graphite bar serves as an anode. However, in this method the boronized layer thickness is often difficult to control. A more preferred method involves therefore electroless boronizing wherein low cost chemicals such as borax and boric acid, are reduced with ferroboron, ferrosilicon, or ferrosilicon magnesium. Activators such as sodium fluoride or sodium chloride are often added.

An even more preferred boronizing method involves the use of solids in powder or paste form. Advantages are easy handling, the possibility of changing the composition of the powder and the need for very little equipment, keeping costs low. The so-called pack boronizing, wherein the substrate is packed in powder or (partially) in paste and thoroughly warmed in a chamber furnace is especially attractive with regard to the purpose of the invention. Various mixtures of boron carbide and for instance potassium fluoroborate may be used. Also amorphous boron or ferroboron and an activator may be applied. In the process of boronizing not only boron may diffuse into the iron phase of the iron based substrate, but also other elements which are present in the gas, liquid or solid compounds, to which the iron based substrate is exposed, may diffuse into the matrix. Especially, elements such as chromium, titanium, aluminium, zirconium and vanadium may intentionally be used for this purpose. This process is referred to as a multiple component boronizing process. The borides formed with these elements may have advantageous properties in terms of the microstructure obtained by this process and the mechanical properties following from these microstructures. Those skilled in the art will be able to apply this particular method with benefit to the purpose of the invention.

With any of these boronizing processes it is possible to obtain an outer layer which comprises at the very surface about 50 at.% boron, presumably leading to iron boride (FeB/Fe₂B) formation. This highly boron enriched iron based surface seems to act as a diffusion barrier for both iron and carbon and seems to suppress the formation of graphite during the deposition of diamond. The concentration of boron in the outer layer drops gradually off with larger depths from the surface towards no more than anyway present in the unaffected matrix of the iron-based substrate. The structure of the outer layer usually comprises more towards the matrix of the iron based substrate, a combination of phases of FeB and Fe₂B, followed by Fe₂B and/or an iron base matrix with an enhanced concentration of boron as compared to the concentration of boron in the iron based substrate before boronizing took place. Also borides of elements which are in the iron-based substrate used as alloying elements may be present. As a consequence of the changing boron concentration, also the mechanical properties change with the depth from the surface of the outer layer. At the very surface the properties are closer to the properties of diamond and the larger the depth from the surface, the closer the properties of the outer layer approach the properties of the unaffected matrix of the iron based substrate.

As a property such as the hardness gradually tails off from the diamond/outer layer interface to a certain depth from the substrate surface, the diffusion modified iron substrate acts as a kind of buffer zone between the diamond and the unaffected matrix of the iron based substrate. This allows for accommodation of the thermal stress which is generated during cooling down the iron based substrate with the CVD diamond coating from the deposition temperature.

According to a further preferred embodiment, the boronizing is carried out at a relatively high temperature at which the iron-based substrate comprises a stable austenite phase. This allows for a reasonably fast boronizing process. For austenitic steels this rapid in-diffusion is simply due to the raised temperature enhancing the speed of a thermally driven process. In addition to this temperature effect, ferritic steels will experience a phase transformation into the austenitic structure, which is an advantage as the diffusivity of boron in austenite is at elevated temperatures about twice the diffusivity of boron in ferrite.

It is further preferable that boronizing is alternated by annealing. With the term "annealing" is meant keeping the substrate with the outer layer on a temperature at which it is possible that the structure minimizes its internal strain energy. Ideally, the annealing occurs at a temperature lower than the temperature at which boronizing takes place. For ferritic steels this would preferably occur at a temperature below the temperature at which both austenite and ferrite are stable. For instance, the solubility of carbon in borides is negligibly low. The presence of carbon is believed to slow down the boronizing process. By annealing, that is dropping the temperature, the in-diffusion of boron will almost stop. It is believed that at the annealing temperature the carbon atoms get an opportunity to diffuse away from the borides into the matrix of the iron phase which has a higher carbon solubility than the borides. After all, the diffusivity of boron in ferritic mild steel is, at for example 650° C, about four orders of magnitude lower than the diffusivity of carbon in ferrite. This allows in a relatively short time span for diffusion of carbon away from the borides, therewith usually also minimizing lattice strain. By repeating this cycle of boronizing and annealing, an outer layer with a boride structure which is suitable for hosting a CVD diamond coating is obtained.

Microstructural analysis of an austenitic steel and a ferritic steel which have been subjected to cycles of boronizing and annealing has revealed for both substrates a 40-50 micrometer thick borided layer. The XRD patterns of the boronized steel layers showed the presence of FeB, and Fe₂B. The Vickers hardness of both surfaces of the outer layer appeared to be up to 3800, a significant improvement as compared to surface of nitrided and carburized iron based substrates with Vickers hardness up to around 1000. Hardness measurements taken along a line from the surface of the outer layer towards the matrix of the steel substrates, show that the further the measurement is from the surface of the outer layer, the lower the hardness is and the closer the hardness lies near the hardness of the matrix of steel (260 for the austenitic steel and 550 for the ferritic steel). This gradual drop in hardness allows the boronized steel surface to be a good hosting substrate for CVD diamond. The number of cycles of boronizing and annealing, the timespans during which is boronized and during which is annealed, and the temperatures at which is boronized and at which is annealed form parameters by which the thickness, microstructure, hardness and so forth are controlled.

It is further preferable that the method comprises
- heating said iron-based substrate which comprises the outer layer to an elevated temperature which is within a range of 135°C to 1200°C;
- exposing said iron-based substrate which comprises the outer layer to a gas mixture containing a carbonaceous gas;
- activating said gas mixture.

This offers a wide scope of parameters for the CVD diamond deposition process The lower the elevated temperature of the iron-based substrate which comprises the outer layer, the lower the thermal stress generated upon cooling down from deposition temperature and the lower the growth rate of the coating. For a thin coating this is no problem. A low temperature of the iron-based substrate during CVD diamond deposition may also be preferred in order to avoid major structural changes in the matrix. As post deposition machining of the diamond coating is undesired if not impossible, the substrate temperatures are kept low during CVD diamond deposition to remain the narrow tolerances in dimensions. This is particularly important in cases where the diamond coating is applied to precision tools. The gas mixture may comprise the gas mixtures commonly used in the different reactors known to be suitable for CVD diamond deposition. Methane and hydrogen are suitable for a Hot Filament Reactor and for instance acetylene and oxygen are suitable for a Flame Reactor. Activating the gas mixture is carried out by the methods commonly used in a reactor selected out of the group consisting of, a hot filament reactor, a flame reactor, an arc-jet reactor and any plasma activated reactors such as a microwave reactor and a radio frequency activated reactor.

In a further preferred embodiment of a method according to the invention said gas mixture comprises initially an excess of carbonaceous gas to allow for a reduction of an incubation time for nucleation of diamond crystallites. This ensures sufficient coverage of the surface of the outer layer to obtain a diamond coating which is fully adherent to the outer layer.

Furthermore, by providing many small diamond crystallites close to the interface of the diamond coating and the outer layer of the iron based substrate, the coating will inherently contain a large volume fraction of grain boundaries. Often the grain boundaries comprise of forms of carbon which are less dense than diamond. For that reason the grain boundaries are much better capable of dealing with the residual stress in the diamond coating after cooling down from the deposition temperature.

Also methods known as bias enhanced nucleation may be applied to obtain such a coating with many small diamond crystallites. In this method the substrate is biased with respect to for instance the feed-in passage of the gas mixture of the reactor.

So-called nanocrystalline diamond coatings comprising diamond crystallites with dimensions in the order of nanometers or some tens of nanometers may also easily be formed by those skilled in the art.

After depositing a diamond coating with small crystallites the growth conditions may be changed such that growth of the diamond crystallites is favoured over the nucleation of diamond crystallites. Hereto, the excess of carbonaceous gas is reduced with respect to the excess used in the preliminary stages of CVD diamond deposition.

Those skilled in the art of diamond deposition will be capable of optimising the deposition parameters to obtain diamond coatings with desired characteristics. These parameters comprise, the pressure in the reactor, the substrate temperature, the gas concentration, the gas flow rate, the activation means and various other parameters related to the activation means. The characteristics comprise grain size, surface morphology, and the contributions of forms of carbon which are less dense than diamond.

In a further preferred embodiment the method according to the invention comprises after depositing the diamond coating on the outer layer a step of controlled cooling down the iron-based substrate with the outer layer and the diamond coating at a controlled cooling rate which is slower than the cooling rate obtained by uncontrolled cooling. Preferably, the iron-based substrate with the outer layer and the diamond coating are cooled down at at a cooling rate of 20 °C or less per minute. Without wishing to be bound by theory, it is believed that the advantage of this step is that at such a slow cooling rate there is still time to redistribute atoms within the structure of the outer layer and/or within the iron based substrate, therewith minimizing the thermal stress. As a result the likelihood that a diamond coating delaminates from the iron based substrate during cooling is believed to be reduced. Also the likelihood that the diamond coating delaminates during practical use is reduced.

In a further advantageous embodiment of the method according to the invention, said outer layer is mechanically scratched prior to depositing the diamond coating. This may lead to better adhesion of the deposited diamond coating due to an enhanced roughness of the surface. Fine grains, with dimensions in the order of one or some micrometers may be used for scratching the outer layer. Preferably, grains are used with a hardness higher than the hardness of the outer layer. Even more preferably, cubic boron nitride grains and/or diamond grains are used as in that case small fragments of the cubic boron nitride and/or the diamond may be embedded in the outer layer and form sites where hetero-epitaxial or homo-epitaxial growth of diamond can take place. This enhances the nucleation rate of the CVD diamond process.

Those skilled in the art of CVD diamond deposition will apply well known cleaning procedures of the substrate and outer layer before depositing CVD diamond. These cleaning procedures may be combined with ultrasonic abrasion. In such a process the substrate with the outer layer is ultrasonically abraded for some or some tens of minutes in a solution comprising fine powder of a material with a hardness which is higher than the hardness of the outer layer. Also in this case, for the same reason as stated above, cubic boron nitride and/or diamond may be used. A solution comprising 0.25 grams of diamond powder ( 1-2 micrometer) in 20 milliliter of isopropanol may be applied in this step. After ultrasonically abrading the outer layer of the substrate properly cleaning and drying is generally applied..

It should further be borne in mind that the thickness of the diamond coating can easily be controlled by parameters which influence the nucleation rate and/or growth rate. A very thin coating is often referred to as a film. A film may be used in applications where a low friction coefficient of the surface of the diamond coating is required. A thick coating may be used in application where the properties related to wear resistance are of importance. In general, it should be borne in mind that the lower the residual stress in the diamond coating, the thicker the coating can be without meeting negative effects. The thickness of the diamond coating may also depend on the specific type of iron based substrate. Steels with a relatively low thermal expansion coefficient within the relevant temperature ranges may allow for a thicker diamond coating.
Those skilled in the art may easily find a suitable combination of type of steel or other iron-based substrate, method of providing the outer layer and the desired characteristics of the diamond coating.

The present invention will now be further illustrated while referring to the following, non-limiting examples.

### EXAMPLE 1

A ferritic tool steel with a matrix Vickers hardness of 550 is boronized by a packed boronizing process. Hereto is a mixture of boron carbide, silicon carbide and potassium fluorocarbide used. Boronizing is carried out at a temperature of 950 °C for 1 hour and alternated by annealing for about 15 minutes at a temperature of 650°C just under the temperature at which both austenite and ferrite are stable. This cycle of boronizing and annealing is carried out four times after which the tool steel substrate is cooled down in air.
X-ray diffraction investigations show the presence of significant amounts of Fe₂B and CrB₄ and small concentrations of FeB. SEM investigations show the presence of an outer layer of about 40 - 50 µm thick with needle shaped borides. Also a high fraction of interdendritic spherical boride particles is observed. Such a microstructural state generally results from a boron concentration which decreases from the surface of the outer layer towards the matrix. Also chromium boride phases are distributed uniformly as fine precipitates within the iron boride layer. The Vickers hardness drops from about 3780 VHN at the surface of the boronized outer layer to about 2570 VHN at 20 micrometer from the surface to about 880 VHN in a transition zone comprising both borides and iron phases.

CVD diamond deposition is carried out in a Hot-Filament CVD reactor. The substrate temperature is kept at about 650 °C, the temperature of the filament is kept at about 2100°C and the distance between the filament and the substrate is kept at about 10 mm. During the first 15 minutes of the CVD diamond deposition process a gas mixture of 1% methane in hydrogen is used. After these first 15 minutes a gas mixture 0.5 % methane in hydrogen is used. The CVD diamond deposition process is carried out for about 4 hours, after which the substrate is cooled down with a cooling rate of 20 °C per minute. SEM observations show on the substrate a uniform, homogeneous and adherent diamond film. Faceted diamond crystallites with a few twin structures were observed. The crystallite size of the diamond film- was approximately 2-3 µm. The diamond grains are well-facetted. Raman peaks are observed at about 1335 cm⁻¹, corresponding to a residual stress of less than 2 GPa.

### EXAMPLE 2

An AISI 316 steel substrate with a matrix Vickers hardness of 260 is boronized by a packed boronizing process. Hereto is a mixture of boron carbide, silicon carbide and potassium fluorocarbide used. Boronizing is carried out at a temperature of 950 °C for 1 hour and alternated by annealing for about 15 minutes at a temperature of about 600 °C-650 °C where the diffusivity of boron is very low as compared to interstitials such as carbon. This cycle of boronizing and annealing is carried out four times after which the austenitic steel substrate is cooled down in air.
X-ray diffraction investigations show the presence of significant amounts of FeB, Fe₂B and Cr₅B₃ phases. SEM investigations show the presence of an outer layer of about 40 - 50 µm thick with layers of borides with planar growth interfaces. The Vickers hardness drops from about 3800 at the surface of the boronized outer layer to about 1250 at 20 micrometer from the surface to about 270 close to the unaffected matrix of the steel.
CVD diamond deposition is carried out in a Hot-Filament CVD reactor. The substrate temperature is kept at about 650 °C, the temperature of the filament is kept at about 2100°C and the distance between the filament and the substrate is kept at about 15 mm. The gas mixture during the CVD diamond deposition was of 0.5 % methane in hydrogen.

Nanocrystalline so-called cauliflower diamond crystallites are formed. The diamond film is uniform and continuous. The crystallite sizes are found to be about 80 - 300 nm. The diamond grains are well-facetted, i.e. little to no twinning is observed. Raman spectroscopy shows the good quality and low residual stress of the deposited diamond film.

## Claims

1. A method of forming a diamond coating on an iron-based substrate, comprising:
• providing an iron based substrate with an outer layer which substantially comprises metal borides; and
• depositing the diamond coating on the outer layer using a process of Chemical Vapour Deposition (CVD).

2. Method according to claim 1, wherein said outer layer is formed by deposition.

3. Method according to claim 1, wherein said outer layer is formed by depositing a metal layer which is capable of being boronized followed by boronizing said metal layer.

4. Method according to claim 1, wherein said outer layer is formed by boronizing said iron-based substrate.

5. Method according to claim 4, wherein the boronizing is carried out at a relatively high temperature at which the iron-based substrate comprises a a stable austenite phase

6. Method according to claim 5, wherein the boronizing is alternated by annealing.

7. Method according to any one of the previous claims, comprising
• heating said iron-based substrate which comprises the outer layer to an elevated temperature which is within a range of 135°C to 1200°C
• exposing said iron-based substrate which comprises the outer layer to a gas mixture containing a carbonaceous gas;
• activating said gas mixture.

8. Method according to claim 7, wherein said gas mixture comprises initially an excess of carbonaceous gas to allow for a reduction of an incubation time for nucleation of diamond crystallites.

9. Method according to any one of the previous claims, further comprising after depositing the diamond coating on the outer layer a step of controlled cooling down the iron-based substrate with the outer layer and the diamond coating at a controlled cooling rate which is slower than the cooling rate obtained by uncontrolled cooling.

10. Method according to any one of the previous claims, comprising prior to depositing the diamond coating mechanically scratching said outer layer.

11. Use of an iron-based substrate comprising an outer layer with substantially borides for hosting a CVD diamond coating.
